(19) Europäisches Patentamt
European Patent Office
Office européen des brevets

(11) EP 2 328 273 A1

(12) EUROPEAN PATENT APPLICATION

(43) Date of publication:
01.06.2011 Bulletin 2011/22

(51) Int Cl.:
H03M 1/60 (2006.01)

(21) Application number: 09177255.8

(22) Date of filing: 26.11.2009

(84) Designated Contracting States:
AT BE BG CH CY CZ DE DK EE ES FI FR GB GR HR HU IE IS IT LI LT LU LV MC MK MT NL NO PL PT RO SE SI SK SM TR
Designated Extension States:
AL BA RS

(71) Applicant: NXP B.V.
5656 AG Eindhoven (NL)

(72) Inventors:
• Collados, Manel
5656 AE, Eindhoven (NL)

• Sinderen, Jan van
5656 AE, Eindhoven (NL)
• Pavlovic, Nenad
5656 AE, Eindhoven (NL)
• He, Xin
5656 AE, Eindhoven (NL)

(74) Representative: Ashton, Gareth Mark et al
NXP Semiconductors
Intellectual Property Department
Betchworth House
67-65 Station Road
Redhill, Surrey RH1 1DL (GB)

(54) **Digital radio frequency modulators**

(57) Various digital RF modulators are proposed. A first proposed RF modulator comprises a quantization noise shaper (50) adapted to modify quantisation noise resultant from an interpolator of the RF modulator such that the quantisation noise at a predetermined frequency is reduced. A second proposed RF modulator comprises first (80A) and second (80B) RF modulators adapted to be controlled by first and second clock signals, respectively, wherein the second clock signal is a delayed version of the first clock signal.

FIG. 11

EP 2 328 273 A1

**Description**

This invention relates to digital radio communication systems and, more particularly, to digital radio frequency (RF) modulators for wireless transmission in such systems.

The use of digital RF modulators for wireless transmitters, while being very attractive when implemented in deep-submicron CMOS, presents two major drawbacks: unfiltered quantization noise and unfiltered aliases.

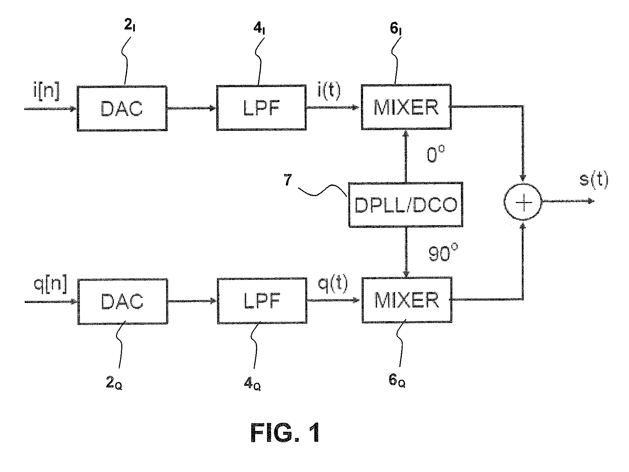

The block diagram of a conventional RF IQ transmitter is shown in Fig. 1. The RF transmitter of Fig. 1 employs a well-known process called "IQ Modulation", where "I" is the "in-phase" component of the waveform, and "Q" represents the quadrature component. Here, digital I and Q signals i[n] and q[n] are passed through respective digital-to-analogue (DAC) convertors $2_I$ and $2_Q$ followed by respective Low-Pass Filters (LPFs) $4_I$ and $4_Q$ so as to produce time varying I and Q signals i(t) and q(t). The I and Q signals i(t) and q(t) are each provided to respective mixers $6_I$ and $6_Q$ where they are mixed with In-phase and quadrature phase signals output from a Digital Phase Locked Loop (DPLL) or Digital Controlled Oscillator (DCO) circuit 7. After mixing, the I and Q signals output from the mixers $6_I$ and $6_Q$ are combined to provide output signal s(t).

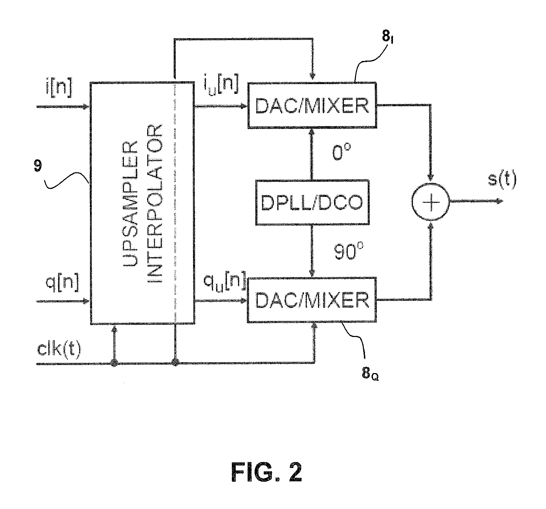

The block diagram of a known direct-digital IQ transmitter is shown in Fig. 2. Here the digital to analog conversion and up-mixing are combined into a signal block 8 for each of the I and Q signals. Moreover, the analog reconstruction filters are replaced by digital interpolation filters and up-samplers within an upsampler and interpolation unit 9.

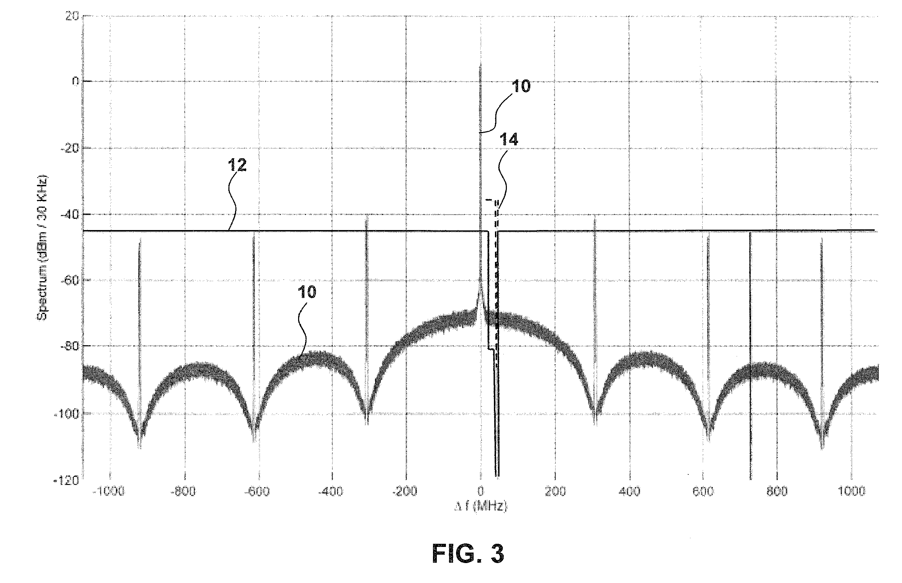

In Fig. 3, the simulated WCDMA output spectrum 10 of the direct-digital RF modulator depicted in Fig. 2 is shown. In this simulation, two 10-bit direct-digital modulators (for I and Q) operating at 307.2 MHz are assumed. The spurious emission mask is shown with a solid line 12. Both the quantization noise and the aliases are filtered by the sample-and hold action taking place in the digital-to-analog conversion. This translates into the well-known sinc(pi f/fs) function in the frequency domain. This simulation corresponds to Band V of the ETSI TS 25.101 cellular standard. In this particular case, the receive band is very close to the transmitter band and the quantization noise is hardly filtered by the sinc function.

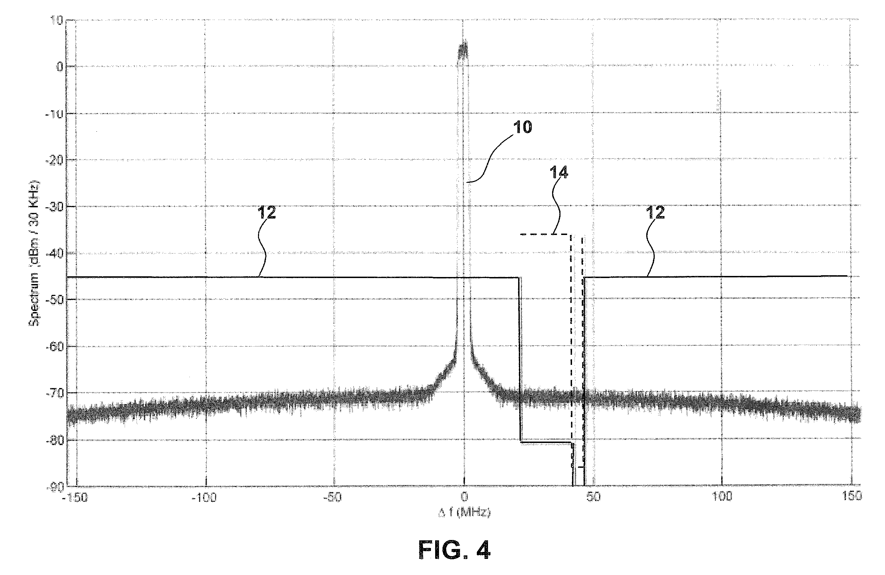

Fig. 4 shows a close-up view of the simulated spectrum of Fig. 3.

In frequency-division duplex (FDD) systems, a duplexer is used to connect the transmitter, receiver and antenna nodes. A duplexer is a three port device which:

- allows "output" signals in the transmission (TX) frequency band to reach the antenna;
- allows "input" signals in the reception (RX) frequency band to reach the receiver;
- isolates the receiver from all "output" signals from the transmitter; and
- filters "output" signals outside the TX in their way to the antenna.

Accordingly, the filtering provided by the duplexer prevents TX power from saturating the receiver, reduces TX noise contribution into the receive channel and filters TX spurious emissions at the antenna. Taking this into account, it is possible to derive a more relaxed spurious emission mask, This is exemplified by the dashed line 14 in Figs 3 and 4. Note, however, that a deep "notch" remains. This notch corresponds to the receive channel, where the TX still has to be particularly clean in order to preserve the receiver's sensitivity.

There are two straightforward solutions to the problem: increase the number of bits to 13 (3 extra bits offer an 18 dB lower quantization noise level), or insert a SAW filter in between the transmitter and the duplexer. The first option is very difficult to implement, and the second one is not desirable because it adds to the bill of materials.

According to the invention, there is provided a digital radio frequency, RF, modulator comprising: a quantization noise shaper adapted to modify quantisation noise resultant from an interpolator of the RF modulator such that the quantisation noise at a predetermined frequency is reduced.

Embodiments may therefore shift the quantization noise out of those frequencies where it can be harmful.

Embodiments may be adapted to create notches in the quantization noise spectrum which are attractive for cellular application, for example, where the spurious emissions are required to be low at certain frequencies whilst being acceptably higher at other frequencies.

According to another aspect of the invention there is provided a digital radio frequency, RF, modulator comprising: first and second RF modulators adapted to be controlled by first and second clock signals, respectively, wherein the second clock signal is a delayed version of the first clock signal. Thus, other embodiments may help to mitigate aliasing products by emulating a higher sample clock without increasing data interpolation.

The use of these techniques separately or combined, allows for realistic direct-digital implementations while complying to the spurious emissions requirements. Further, embodiments may reduce alias levels based on multi-phase clocking, and this may be combined with the proposed noise shaping.

Extra digital signal processing means in the form of an intermediate frequency (IF) shifter may be provided. Such an IF shifter may be adapted to shift the baseband signal to a predetermined IF which, when combined with the concept of multi-phase clocking, can be used to cancel aliases.

Examples of the invention will now be described with reference to the accompanying drawings, in which:

Figure 1 is a block diagram of a conventional RF IQ transmitter;
Figure 2 is a block diagram of a known direct digital-to-RF IQ transmitter;
Figure 3 shows the simulated WCDMA output spectrum of the direct-digital RF modulator of Figure 2;
Figure 4 shows a close-up view of the simulated spectrum of Fig. 3;
Figure 5 is a block diagram of a direct-digital RF modulator according to an embodiment of the invention;
Figure 6 is a block diagram of the quantization noise shaper of the direct-digital RF modulator of Figure 5;
Figure 7 shows the simulated WCDMA output spectrum of the direct-digital RF modulator of Figure 5;
Figure 8 shows a direct-digital RF modulator according to another embodiment of the invention;
Figure 9 shows the simulated WCDMA output spectrum of the direct-digital RF modulator of Figure 8 where the noise-shaping has been turned off;
Figure 10 shows the simulated WCDMA output spectrum of the direct-digital RF modulator of Figure 8 where the noise-shaping has been turned on;
Figure 11 shows a direct-digital RF modulator according to yet another embodiment of the invention; and
Figure 12 shows the theoretical attenuation of a single clocking phase system (plot 120), a two-phase clocking system with t = 0.5/fs (plot 122), and a two-phase clocking with t = 0.47/fs (plot 124) according to the invention.

The drawings are not to scale, and some dimensions may have been exaggerated (for example the thickness dimension) to make the drawings show the different components more clearly.

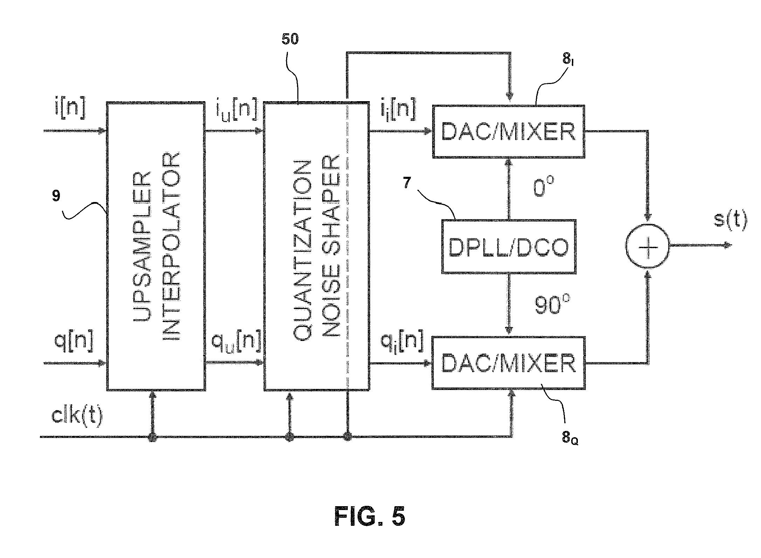

In Fig. 5 a block diagram of a direct-digital RF modulator according to an embodiment of the invention is shown. This RF modulator is similar in construction to the convention RF modulator of Figure 2 except that it further comprises a quantization noise shaper 50.

The quantization noise shaper 50 is adapted to shape the spectrum of the quantization noise introduced when reducing the number of bits with the interpolator. By default, the quantization noise energy is white noise, spreading equally across all frequencies. The noise shaper 50 is adapted to create notches in the quantization noise spectrum, which makes it attractive for cellular application, for example, where the spurious emissions are required to be low at certain frequencies whilst being acceptable to be higher at other frequencies.

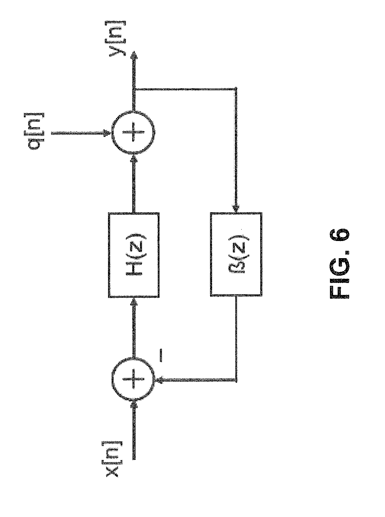

The block diagram of the quantization noise shaper 50 is shown in Fig. 6. The discrete-time input signal x[n] is represented using Ni bits, while the output signal y[n] is represented using No bits wherein Ni > No. The reduction in the number of output bits is performed by the quantizer, where the quantizer is modelled as an addition of quantization noise q[n].

Thus, the transfer function T(z) from input to output as a function of the forward H(z) and feedback β(z) filters can be represented as Equation 1 below:

$$T(z) = H(z) / (1 + H(z)\beta(z)), \qquad\qquad (1)$$

and the transfer function N(z) from the quantization noise to the output can be represented as Equation 2 below:

$$N(z) = 1/ (1 + H(z)\beta(z)) \qquad\qquad (2)$$

Given the a desired T(z) and N(z), the required H(z) and β(z) can therefore be represented as Equations 3 and 4, respectively:

$$H(z) = T(z) / N(z) \qquad\qquad (3)$$

$$\beta(z) = (1 - N(z)) /T(z)) \qquad\qquad (4)$$

In particular, looking at the output spectrum of Fig. 4, we would like to place a zero in the quantization noise transfer function N(z) in the receive channel frequency, say $\omega_0$, in the normalized discrete-time domain. Accordingly, one represents the quantization noise transfer function N(z) using Equation 5 as follows:

$$N(z) = (1 - z_0 z^{-1})\,(1 - z_0{}^* z^{-1}) \qquad (5),$$

wherein $z_0 = e^{j\omega 0}$.

To simplify matters, two conjugated zeros have been used in N(z). A single zero is also possible but then the I and Q branches of the RF modulator cannot be processed by separate noise shapers.

To complete the example we take the transfer function T(z) to be equal to 1 (although in some cases a low-pass characteristic might be desired). Then, the required H(z) and $\beta(z)$ can be represented as Equations 6 and 7, respectively:

$$H(z) = 1 / (1 - 2\cos\omega_0 z^{-1} + z^{-2}) \qquad (6)$$

$$\beta(z) = 2\cos\omega_0 z^{-1} - z^{-2} \qquad (7)$$

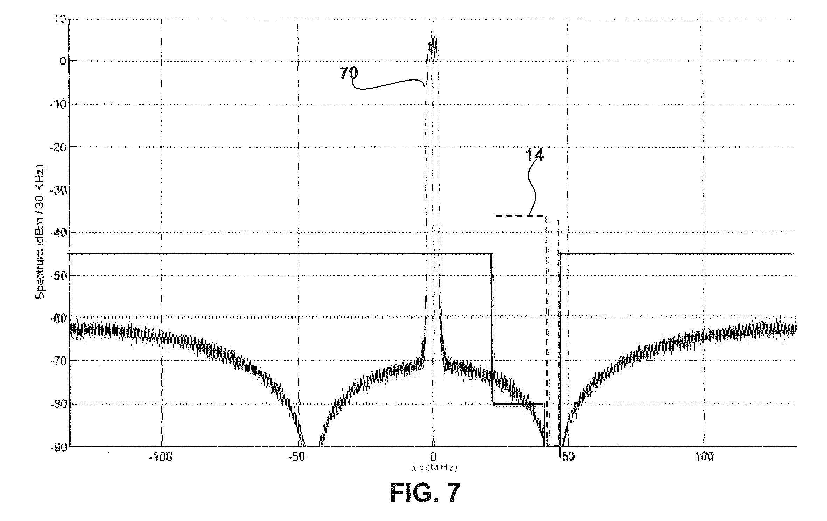

Using the filters as described above in relation to Fig. 6, the simulated WCDMA output spectrum 70 of a direct-digital RF modulator according to Figure 5 is shown in Figure 7. The transmitter uses a 10-bit direct-digital modulators, but now the quantization noise in the receive channel has been shifted out.

More zero's can be added to the quantization noise transfer function N(z) to implement a wider notch and allow for further reduction in the required number of bits. Indeed, using two pairs of conjugated zero's, the number of bits in the direct-digital modulators can be reduced to 8 for this particular example.

Alternatively, a trade-off between the number of bits and the sampling frequency is also possible by keeping number of bits to 10 and reducing sampling frequency, for example.

As shown in Fig. 3, a remaining issue in direct-digital transmitters is the aliases (not visible in Fig. 4 and Fig. 7 because of the enlarged scale). The sampling frequency used in the simulation of Fig. 3, Fig. 4 and Fig. 7 is 307.2MHz. This is represents an oversampling factor of 80 with respect to the WCDMA signal bandwidth.

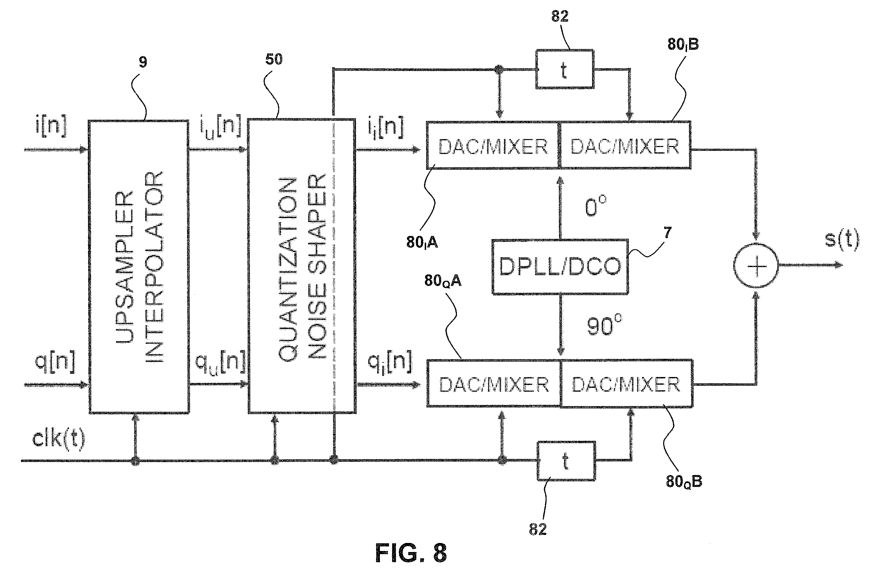

Fig. 8 shows a direct-digital RF modulator according to another embodiment of the invention. This is similar in construction to the embodiment of Figure 5 except that the modulators are split into first $80_I A$ and $80_Q A$ modulators and second $80_I B$ and $80_Q B$ modulators that are adapted to use the same data but clocked at different clocking instants. Specifically, the clocks of the second modulators $80_I B$ and $80_Q B$ are delayed by delay unit 82 by a time period t with respect to the clocks of the first modulators $80_I A$ and $80_Q A$. This architecture emulates a higher sample clock without increasing the actual data interpolation.

It will be appreciated that the same concept can be extended to more than two modulators and clock phases.

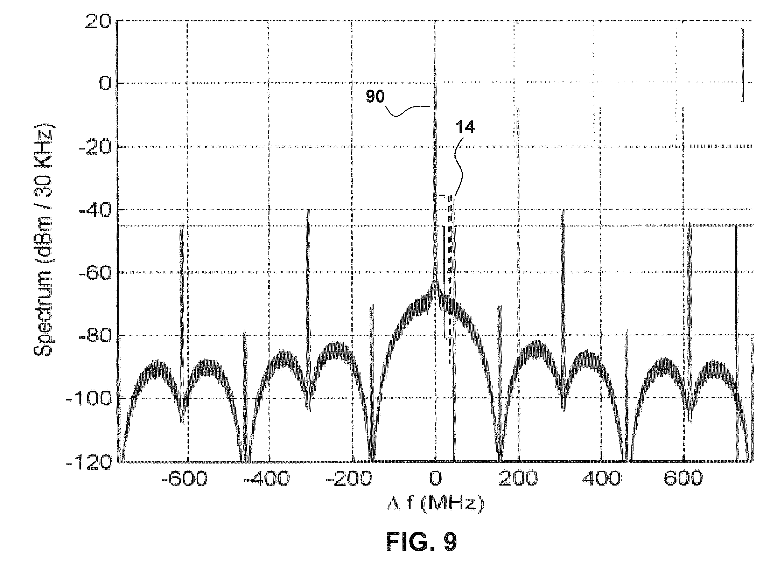

Using the architecture in Fig. 8 with t = 0.511s allows to have aliases levels comparable to those in Fig. 3 but with an oversampling factor of 40 (sampling frequency fs = 153.6MHz). This is shown in the simulated WCDMA output spectrum 90 of Fig. 9 where the noise-shaping has been turn-off to allow for a better comparison with Fig. 3.

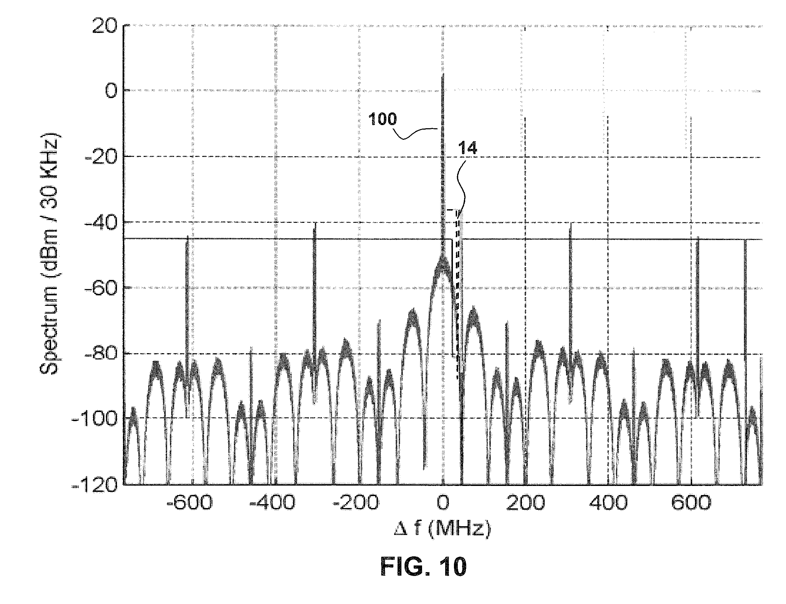

Turning on the noise shaping algorithm yields the simulated WCDMA output spectrum 100 of Fig. 10. This latest picture shows how the benefits of noise-shaping and multi-phase clocking can be combined.

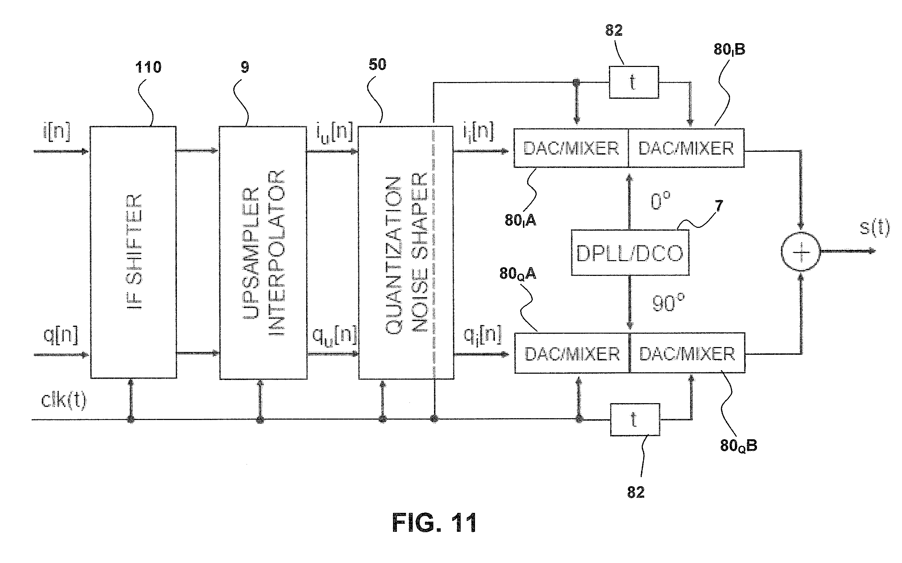

Fig. 11 shows a direct-digital RF modulator according to yet another embodiment of the invention. This is similar in construction to the embodiment of Fig. 8 except that it further comprises extra digital signal processing means in the form of an intermediate frequency (IF) shifter 110 adapted to shift the baseband signal to a predetermined IF. The combination of the IF-shift and the multi-phase clocking can be used to cancel aliases. As with the embodiment of Fig. 8, the concept can be extended to more than two modulators and clock phases.

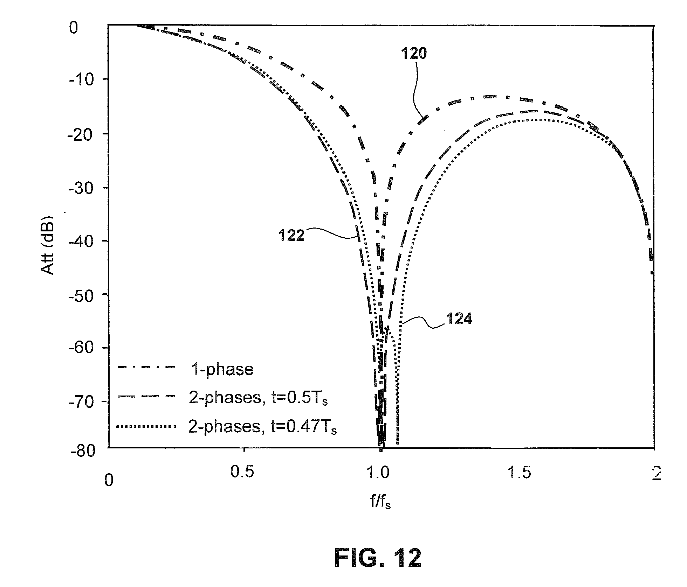

To conclude Fig. 12 shows the theoretical attenuation of a single clocking phase system (plot 120), a two-phase clocking system with t = 0.5/fs (plot 122), and a two-phase clocking system with t = 0.47/fs (plot 124). Note how, in the third case (a two-phase clocking system with t = 0.47/fs), an attenuated band is achieved. This can be used to optimize the cancellation of aliases in those applications where the signal bandwidth is too large for the alias to be sufficiently attenuated by a single notch. Since the attenuated band is shifted with respect to the sampling frequency, this method has to be accompanied by an IF-shift of the baseband signal (see Fig. 11). It will be appreciated that the optimum IF-shift and t will depend on the signal bandwidth.

Proposed embodiments are adapted to remove or reduce quantization noise at frequencies where it can be harmful or detrimental. Embodiments also employ a technique to mitigate aliasing products. The use of these techniques separately or a combination of the two allows for realistic direct-digital implementations while complying to the spurious emissions requirements.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. Any reference signs in the claims should not be construed as limiting the scope.

**Claims**

1. A digital radio frequency, RF, modulator comprising:

   a quantization noise shaper (50) adapted to modify quantisation noise resultant from an interpolator of the RF modulator such that the quantisation noise at a predetermined frequency is reduced.

2. The RF modulator of claim 1, wherein the quantization noise shaper (50) has a noise transfer function, N(z), from quantisation noise input to RF modulator output, and wherein the quantization noise shaper (50) is arranged such that the noise transfer function, N(z), is substantially equal to zero for the predetermined frequency.

3. The RF modulator of claim 1 or 2, wherein the quantization noise shaper (50) has a transfer function, T(z), from RF modulator signal input to RF modulator output, and wherein the quantization noise shaper is arranged such that the transfer function, T(z), is substantially equal to one for the predetermined frequency.

4. The RF modulator of claim 3, wherein the quantization noise shaper (50) comprises a forward filter and a feedback filter, and wherein the quantization noise shaper is arranged such that the transfer function T(z) is represented by the equation:

$$T(z) = H(z) / (1 + H(z)\beta(z)),$$

   where H(z) is the transfer function of a forward filter and $\beta(z)$ is the transfer function of a feedback filter.

5. The RF modulator of claim 4, when dependent on claim 2, wherein the quantization noise shaper (50) is arranged such that the transfer function H(z) of the forward filter is represented by the equation:

$$H(z) = 1 / (1 - 2\cos\omega_0 z^{-1} + z^{-2})$$

   and the transfer function of a feedback filter is represented by the equation:

$$\beta(z) = 2\cos\omega_0 z^{-1} - z^{-2},$$

   where $\omega_0$ is the predetermined frequency in the normalized discrete-time domain, and $z_0 = e^{j\omega 0}$.

6. The RF modulator of any previous claim further comprising:

   first and second RF modulators adapted to be controlled by first and second clock signals, respectively, wherein the second clock signal is a delayed version of the first clock signal.

7. A digital radio frequency, RF, modulator comprising:

first (80A) and second (80B) RF modulators adapted to be controlled by first and second clock signals, respectively,
wherein the second clock signal is a delayed version of the first clock signal.

8. The RF modulator of claim 7 further comprising an intermediate frequency shifter (110) adapted to shift a baseband input signal to a predetermined intermediate frequency.

9. The RF modulator of claim 7 or 8, further comprising a quantization noise shaper (50) adapted to modify quantisation noise resultant from an interpolator of the RF modulator such that the quantisation noise at a predetermined frequency is reduced.

10. A digital RF modulation process comprising the step of:

    modifying quantisation noise resultant from an interpolation process such that the quantisation noise at a predetermined frequency is reduced.

11. A digital RF modulation process comprising the step of:

    controlling first and second RF modulation processes with first and second clock signals, respectively,
    wherein the second clock signal is a delayed version of the first clock signal.

12. The digital RF modulation process of claim 11 further comprising the step of:

    shifting a baseband input signal to a predetermined intermediate frequency.

13. The digital RF modulation process of claim 11 or 12 further comprising the step of:

    modifying quantisation noise resultant from an interpolation process such that the quantisation noise at a predetermined frequency is reduced.

14. A computer program comprising computer program code means adapted to perform all the steps of any of claims 10 to 13 when said program is run on a computer.

15. A computer program as claimed in claim 14 embodied on a computer readable medium.

**FIG. 1**

FIG. 2

**FIG. 3**

EP 2 328 273 A1

FIG. 4

**FIG. 5**

FIG. 6

**FIG. 7**

FIG. 8

FIG. 9

FIG. 10

FIG. 11

FIG. 12

Europäisches
Patentamt
European
Patent Office
Office européen
des brevets

# EUROPEAN SEARCH REPORT

Application Number

EP 09 17 7255

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANTOINE FRAPPE ET AL: "All-digital RF signal generation for software defined radio" CIRCUITS AND SYSTEMS FOR COMMUNICATIONS, 2008. ECCSC 2008. 4TH EUROPEAN CONFERENCE ON, IEEE, PISCATAWAY, NJ, USA, 10 July 2008 (2008-07-10), pages 236-239, XP031315031 ISBN: 978-1-4244-2419-1 | 1-3,9, 10,14,15 | INV. H03M1/60 |
| Y | * figures 1,3,5 * | 5 | |
| Y | EP 2 037 585 A1 (ST MICROELECTRONICS NV [NL]; ST MICROELECTRONICS SA [FR]) 18 March 2009 (2009-03-18) * figures 4,5 * | 2-9, 11-13 | |
| Y | EP 2 037 584 A1 (ST MICROELECTRONICS NV [NL]; ST MICROELECTRONICS SA [FR]) 18 March 2009 (2009-03-18) * figure 13 * | 6-13 | |
| Y | LEE H-S ET AL: "Radio Frequency Digital-to-Analog Converter" IEEE JOURNAL OF SOLID-STATE CIRCUITS, IEEE SERVICE CENTER, PISCATAWAY, NJ, US LNKD-DOI:10.1109/JSSC.2004.829377, vol. 39, no. 9, 1 September 2004 (2004-09-01), pages 1462-1467, XP011117965 ISSN: 0018-9200 * the whole document * | 6-13 | TECHNICAL FIELDS SEARCHED (IPC) H03M |

-/--

The present search report has been drawn up for all claims

| Place of search | Date of completion of the search | Examiner |
|---|---|---|
| Munich | 27 April 2010 | Müller, Uta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 09 17 7255

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | SHAHIN MEHDIZAD TALEIE ET AL: "A Linear â Digital IF to RF DAC Transmitter With Embedded Mixer"<br>IEEE TRANSACTIONS ON MICROWAVE THEORY AND TECHNIQUES, IEEE SERVICE CENTER, PISCATAWAY, NJ, US,<br>vol. 55, no. 5, 1 May 2008 (2008-05-01), pages 1059-1068, XP011206782<br>ISSN: 0018-9480<br>* figure 2 *<br>----- | 6-13 | |
| Y | TALEIE S M ET AL: "A Bandpass /spl Delta//spl Sigma/ RF-DAC with Embedded FIR Reconstruction Filter"<br>DIGEST OF TECHNICAL PAPERS / 2006 IEEE INTERNATIONAL SOLID-STATE CIRCUITS CONFERENCE : SAN FRANCISCO, CA, 5 - 9 FEBRUARY 2006, IEEE SERVICE CENTER, PISCATAWAY, NJ , US LNKD-DOI:10.1109/ISSCC.2006.1696300,<br>6 February 2006 (2006-02-06), pages 2370-2379, XP010940644<br>ISBN: 978-1-4244-0079-9<br>* the whole document *<br>----- | 6-13 | |
| Y | HAO SAN ET AL.: "Complex Bandpass Delta Sigma AD Modulator with Nouse-coupled Image Rejection"<br>IEEE, 2 August 2009 (2009-08-02), - 5 August 2009 (2009-08-05) pages 357-360, XP002579816<br>* Equations 2, 3,6 figure 5 *<br>----- | 2-6 | **TECHNICAL FIELDS SEARCHED (IPC)** |

-/--

The present search report has been drawn up for all claims

| Place of search | Date of completion of the search | Examiner |
|---|---|---|
| Munich | 27 April 2010 | Müller, Uta |

Europäisches
Patentamt

European
Patent Office

Office européen
des brevets

**EUROPEAN SEARCH REPORT**

Application Number

EP 09 17 7255

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | AL-JANABI M ET AL: "Methods for the transfer function design of multiple narrow-band bandpass sigma-delta modulators" COMPUTER STANDARDS AND INTERFACES, ELSEVIER SEQUOIA. LAUSANNE, CH LNKD-DOI:10.1016/S0920-5489(01)00062-9, vol. 23, no. 2, 1 May 2001 (2001-05-01), pages 85-102, XP004232990 ISSN: 0920-5489 * paragraphs [0004], [0005], [0006] * ----- | 5 | |
| | | | TECHNICAL FIELDS SEARCHED (IPC) |

The present search report has been drawn up for all claims

| Place of search | Date of completion of the search | Examiner |
|---|---|---|
| Munich | 27 April 2010 | Müller, Uta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 17 7255

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2010

| Patent document cited in search report | | Publication date | Patent family member(s) | | Publication date |
|---|---|---|---|---|---|
| EP 2037585 | A1 | 18-03-2009 | US | 2009082006 A1 | 26-03-2009 |
| EP 2037584 | A1 | 18-03-2009 | US | 2009073013 A1 | 19-03-2009 |

EPO FORM P0459

For more details about this annex : see Official Journal of the European Patent Office, No. 12/82